# EUROPEAN PATENT SPECIFICATION

(11) **EP 3 914 056 B1**
(45) Date of publication and mention of the grant of the patent: **27.11.2024**
(21) Application number: 21156148.5
(22) Date of filing: 09.02.2021
(51) Int. Cl.: H05K 5/06, H02G 3/08, F16L 5/06

(54) **ELECTRONIC BOX AND CABLE ADAPTOR ASSEMBLY THEREOF**
ELEKTRONIKGEHÄUSE UND KABELADAPTERANORDNUNG DAFÜR
BOÎTIER ÉLECTRONIQUE ET SON ENSEMBLE ADAPTATEUR DE CÂBLE

(30) Priority: 21.05.2020 CN 202020872899 U
(43) Date of publication of application: 24.11.2021
(73) Proprietor: Sungrow Power Supply Co., Ltd., Hefei, Anhui 230088 (CN)
(72) Inventor: Zhang, Guofeng, Hefei, Anhui 230088 (CN); Li, Yonghong, Hefei, Anhui 230088 (CN); Liu, Long, Hefei, Anhui 230088 (CN)
(74) Representative: Zacco Norway AS

(56) References cited:
- EP-A2- 2 506 375
- CN-U- 202 550 435
- DE-U1- 202006 007 400
- GB-A- 2 121 134
- US-A- 5 942 728
- US-A1- 2003 000 726
- US-A1- 2013 153 290
- US-A1- 2019 097 403
- US-A1- 2020 093 018
- US-B1- 6 268 565
- US-B1- 6 488 317
- US-B1- 6 527 302

## Description

### TECHNICAL FIELD

The present disclosure relates to the technical field of electronic box waterproofing, and in particular to a cable adapter assembly of an electronic box. The present disclosure also relates to an electronic box including the cable adapter assembly.

### BACKGROUND

In order to effectively protect an internal device from influence of water vapor and dust, resulting in electrical performance failure, an electronic box (such as a combiner box, an inverter, etc.) is generally required to reach a protection level of IP65. A waterproof terminal is widely used to waterproof and dustproof a position of a hole where a cable inlet and outlet the electronic box.

The electronic box is designed with an installation hole for installing the waterproof terminal. The waterproof terminal is fixed on the box by clamping nuts and sealing rings to achieve a sealing effect, and the size of the box hole corresponding to the waterproof terminal is fixed. Different waterproof terminals support different cable diameter ranges. When the diameter of the cable exceeds the allowable wire diameter of the waterproof terminal, an effective protection function cannot be achieved.

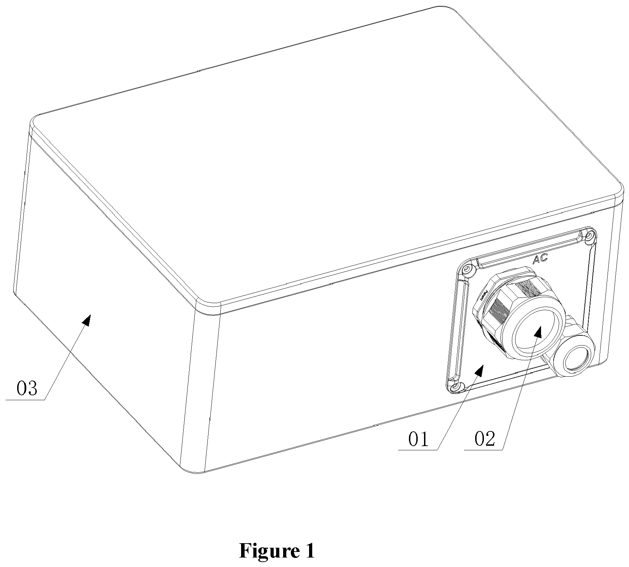

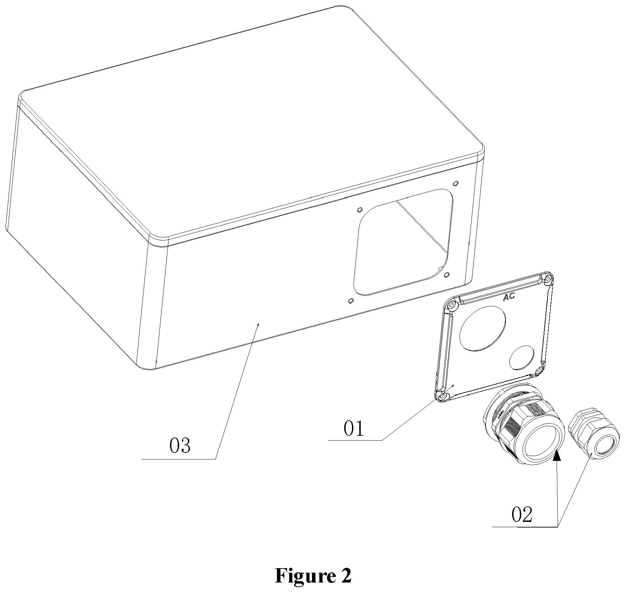

As shown in Figure 1 and Figure 2, in order to adapt the product to the market of different wire diameters, the waterproof terminal 02 is arranged on the sealing plate 01 to form a cable assembly, and the sealing plate 01 is arranged on the box body 03 of the electronic box. Specifically, the box body 03 is provided with a circle hole for installing the waterproof terminal 02. When the waterproof terminal 02 is installed, the terminal body of the waterproof terminal 02 is first sealed and installed at the position of the circle hole by a threaded fastener, and then the locking structure of the waterproof terminal 02 is sealedly connected to the terminal body. When the terminal needs to be replaced, the sealing plate 01 matching the new terminal should be replaced at the same time. All types of sealing plate 01 adopt the same interface with the box.

However, affected by the use time, vibration and installation technology, the installation position of the waterproof terminal 02 and the sealing plate 01 cannot be effectively sealed, resulting in the reduction of the waterproof reliability of the electronic box. And since the waterproof terminal 02 and the sealing plate 01 are separated when the cable adapter assembly is assembled, the terminal body of the waterproof terminal 02 needs to be installed with a nut, and the sealing ring is sealed at the position of the installation hole of the sealing plate 01, resulting in a low assembly efficiency of the electronic box.

Therefore, those skilled in the art have a strong desire is how to improve the assembly efficiency of the electronic box.

US6268565B1 discloses a cable sealing arrangement is provided for limiting the ingress of fluid into a location about a cable, such as a telephone wire enclosure, which generally includes a fitting, two sealing members, and two nuts. The sealing arrangement provides multiple redundant seals defined by the interfaces of tapered surfaces on the sealing members and the fitting, as well as, the interfaces of tapered surfaces on the sealing members and the nuts. By tightening the nuts onto the fitting, the nuts cause compression of the sealing members resulting in tight engagement of a cable.EP2506375A2 discloses a strain relief which has a terminal component having a cable supply port with gasket overlay and cable passage whose diameter is equal to diameter of a cable. A V-shaped gasket having inner aperture corresponding to diameter of cable jacket, is fixed with the gasket overlay of cable supply port. An injection molding material is adhered on the cable jacket and outer material of terminal component such that the V-shaped gasket is sealed with the cable jacket and inner side wall of the cable passage.

US6488317B1 discloses a strain relief which includes a main body having a bore therein for passage of a cable, wire, conduit, hose, or similar member therethrough. The main body includes a first section having male threads, and a second section including a plurality of cantilevered deflectable prongs extending therefrom. A plurality of slots are located between the prongs, and the prongs decrease in width extending toward distal ends of the prongs. A flexible elastomeric grommet is located within the bore and extends substantially along an entire length of the main body. The grommet includes a cylindrical sidewall and a plurality of spaced-apart annular ribs extending radially inwardly from the sidewall. A plurality of annular grooves are located between the annular ribs. The annular ribs have inside diameters which progressively increase along a length of the grommet in order to accommodate cables of various diameters therethrough. A silicone gel may be located in the annular grooves to improve the seal between the grommet and the cable. A cap is provided which includes female threads which are engagable with the male threads of the main body for securing the cap to the main body. The cap includes a conically or arcuately tapered wall engagable with distal ends of the prongs for compressing the prongs inwardly when the cap is threaded onto the main body, thereby compressing the grommet inwardly around the cable. US6527302B1, US2013153290A1, US2019097403A1, GB2121134A, DE202006007400U1, US2003000726A1, US2020093018A1, US5942728A are identified there.

CN202550435U disclose a British Standard Pipe waterproof cable joint which comprises a fixed head, a fastener, a plastic main body and a seal ring, wherein the fixed head is provided with an internal thread; the fastener is provided with an internal thread; the plastic main body comprises a seal area provided with a seal tooth and a connection area; the seal area is provided with an external thread matched with the internal thread of the fixed head; the connection area is provided with an external thread matched with the internal thread of the fastener; the seal ring is radially suitable for being mounted in the plastic main body and being bonded with the inner wall of the seal area; the inner wall of the seal tooth extends towards the central axial direction to form at least one barb; and an annular step matched with the barb is formed in a position where the outer wall of the seal ring and the barb are bonded.

### SUMMARY

An object of the present disclosure is to provide a cable adapter assembly of an electronic box to improve the assembly efficiency of the electronic box. Another object of the present disclosure is to provide an electronic box including the cable adapter assembly.

In order to achieve the above objects, the present disclosure provides a cable adapter assembly according to claim 1.

Preferably, the clamping claw includes an annular tube and multiple claws arranged annularly around the outer circumference of the annular tube, and the terminal body is sleeved outside of the annular tube, one end of the inner wall of the terminal body away from the claws is provided with a limit step for abutting against the end of the annular tube.

Preferably, the waterproof terminal further includes a sealing ring, and the clamping claw is sleeved outside of the sealing ring, and the first end of the sealing ring extends to the outer end surface of the claws.

Preferably, the second end of the sealing ring extends to the outer end surface of the annular tube, and the outer side surface of the sealing ring is connected with the clawing claw, and the first end and the second end are two ends of the sealing ring arranged facing away.

Preferably, the terminal is arranged to protrude from the outer surface of the sealing plate.

An electronic box includes a box body and a cable adapter assembly arranged on the box body. The cable adapter assembly is the cable assembly according to any one of the above.

Preferably, one of the cable adaptor assemblies or at least two of the cable adaptor assemblies are provided on the electronic box.

It can be seen from the above description that in the cable adapter assembly according to the present application, since the terminal body of the waterproof terminal and the sealing plate are integrally processed and formed, that is, when the electronic box is assembled, it is not necessary to separately connect and seal the terminal body and the sealing plate. Therefore, the cable adaptor assembly according to the present application effectively improves the assembly efficiency of the electronic box.

### BRIEF DESCRIPTION OF THE DRAWINGS

For more clearly illustrating embodiments of the present disclosure or the technical solutions in the conventional technology, drawings to be used in the description of the embodiments or the conventional technology will be briefly described hereinafter. Apparently, the drawings in the following description are only some embodiments of the present disclosure. For those skilled in the art, other drawings may be obtained based on the provided drawings without any creative work.
Figure 1 is a schematic diagram showing the structure of the conventional electronic box;
Figure 2 is an exploded view of the electronic box shown in Figure 1;
Figure 3 is a schematic diagram showing the structure of the cable adapter assembly according to an embodiment of the present disclosure;
Figure 4 is an exploded view of the cable adapter assembly shown in Figure 3;
Figure 5 is a schematic diagram showing the structure of the sealing ring and the clamping claw according to the embodiment of the present disclosure;
Figure 6 is a front view of the sealing plate according to the embodiment of the present disclosure;
Figure 7 is a back view of the sealing plate according to the embodiment of the present disclosure;
Figure 8 is a schematic diagram showing the structure of the electronic box according to the embodiment of the present disclosure; and
Figure 9 is an exploded view of the electronic box according to the embodiment of the present disclosure;

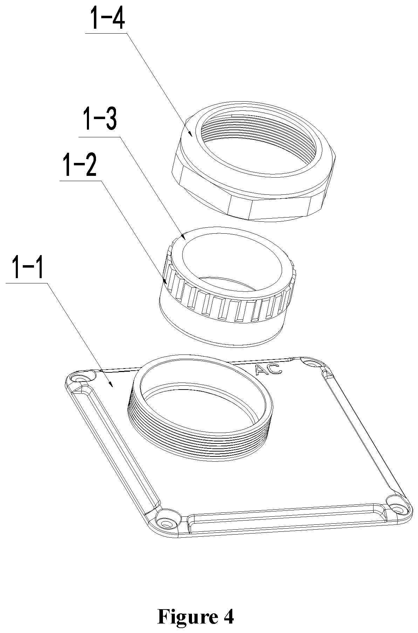

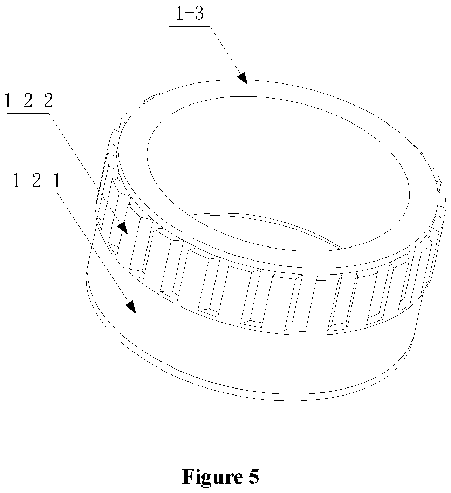

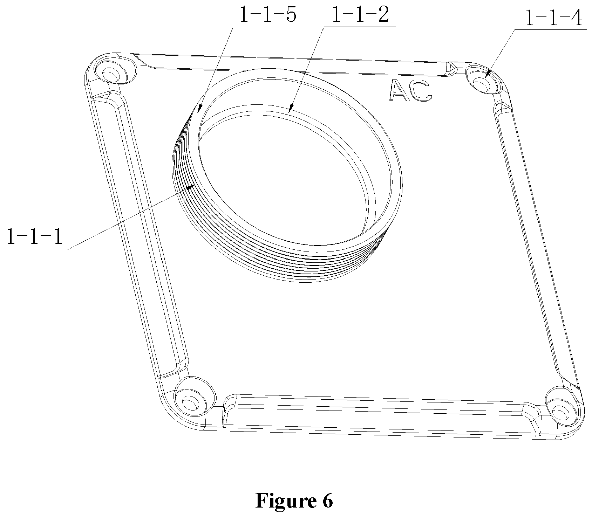

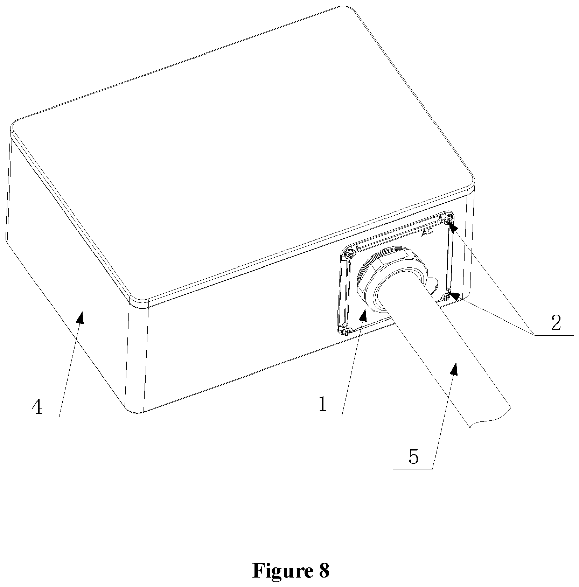

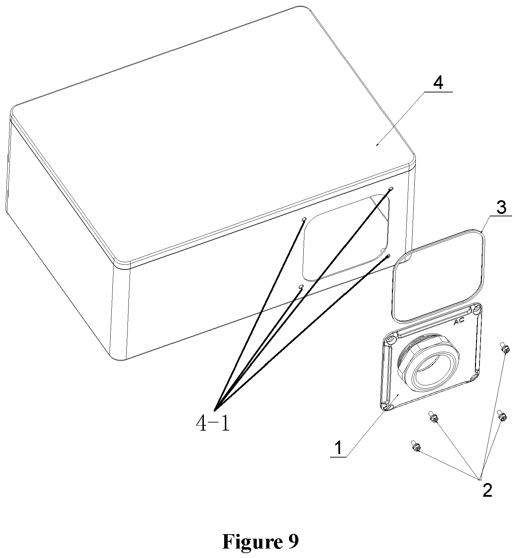

Reference numerals in Figures 1-9:

| | | | |
|---|---|---|---|
| 01. | sealing plate, | 02. | waterproof terminal, |
| 03. | box body | 1. | cable adapter assembly, |
| 1-1. | sealing plate, | 1-1-1. | external thread, |
| 1-1-2. | limit step; | 1-1-3. | annular groove, |
| 1-1-4. | second fastening installation hole, | 1-1-5. | terminal body; |
| 1-2. | clamping claw, | 1-2-1. | annular tube, |
| 1-2-2. | claw | 1-3. | sealing ring, |
| 1-4. | clamping nut, | 2. | threaded fastener, |
| 3. | sealing strip, | 4. | box body, |
| 4-1. | first fastening installation hole, | 5. | cable. |

### DETAILED DESCRIPTION OF THE EMBODIMENTS

The core of the present disclosure is to provide a cable adapter assembly of the electronic box to improve the assembly efficiency of the electronic box. Another core of the present disclosure is to provide an electronic box including the cable adapter assembly.

In order to enable those skilled in the art to better understand the technical solutions of the present disclosure, the present disclosure will be further described in detail below with reference to the drawings and embodiments.

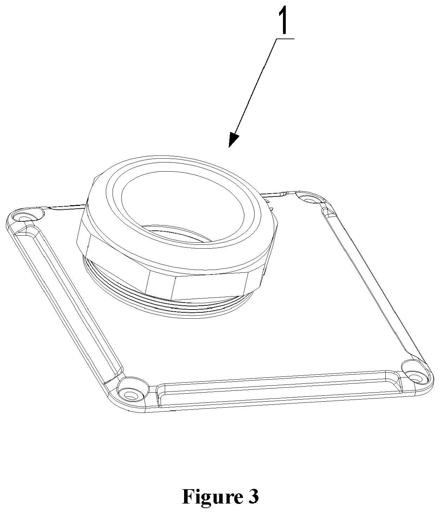

Referring to Figures 3 to 9, in a specific embodiment, the cable adapter assembly of the electronic box according to the specific embodiment of the present disclosure includes a sealing plate 1-1 and a waterproof terminal. The waterproof terminal includes a terminal body 1-1-5, and the terminal body 1-1-5 and the sealing plate 1-1 have an integrated structure. Specifically, the sealing plate 1-1 and the terminal body 1-1-5 may be integral die-casting parts. Specifically, both ends of the terminal body 1-1-5 are through holes, and inside of the terminal body 1-1-5 has a pipeline structure for the cable to pass through, and the waterproof terminal further includes a clamping claw 1-2 and a clamping nut 1-4, the outer wall of the terminal 1-1-5 is provided with an external thread 1-1-1 connected with the clamping nut 1-4, and the terminal body 1-1-5 and the clamping nut 1-4 are sleeved outside of the clamping claw 1-2.

It can be seen from the above description that in the cable adapter assembly 1 according to the specific embodiment of the present application, since the terminal body 1-1-5 of the waterproof terminal and the sealing plate 1-1 are integrally processed and formed, that is, when the electronic box is assembled, it is not necessary to separately connect and seal the terminal body 1-1-5 and the sealing plate 1-1. Therefore, the cable adaptor assembly 1 according to the present disclosure effectively improves the assembly efficiency of the electronic box.

Therefore, the installation man-hours are reduced and the possible failure of the connection is avoided, and the possible sealing failure of the sealing plate 1-1 and the waterproof terminal is avoided, and the cost is greatly reduced.

In a specific embodiment, the clamping claw 1-2 includes an annular tube 1-2-1 and multiple claws 1-2-2 arranged annularly around the outer circumference of the annular tube 1-2-1, and the terminal body 1-1-5 is sleeved outside of the annular tube 1-2-1. One end of the inner wall of the terminal body 1-1-5 away from the claws 1-2-2 is provided with a limit step 1-1-2 for abutting against the end of the annular tube 1-2-1.

Preferably, the claws 1-2-2 are evenly distributed along the circumferential direction of the annular tube 1-2-1. In order to facilitate the cooperation with the clamping nut 1-4, a top end surface of each claw 1-2-2 is an inclined guide surface.

Specifically, the limit step 1-1-2 may be arranged in an annular. The inner diameter of the limit ring is smaller than the inner diameter of the terminal body 1-1-5. Preferably, the outer diameter of the clamping claw 1-2 is equal to the inner diameter of the terminal body 1-1-5, or the outer diameter of the clamping claw 1-2 is slightly smaller than the inner diameter of the terminal body 1-1-5, and at the same time greater than the inner diameter of the limit ring.

In order to improve the sealing performance, the waterproof terminal further includes a sealing ring 1-3, and the clamping claw is sleeved outside of the sealing ring 1-3, and the first end of the sealing ring 1-3 extends to the outer end surface of the claws 1-2-2.

Preferably, the second end of the sealing ring 1-3 extends to the outer end surface of the annular tube 1-2-1, and the outer side surface of the sealing ring 1-3 is connected with the clawing claw 1-2. Specifically, the sealing ring 1-3 has an integrally processed and formed structure preferably. And the first end and the second end are two ends of the sealing ring 1-3 arranged facing away.

When the cable adapter assembly 1 is assembled, the clamping claw 1-2 is arranged in the sealing plate 1-1, and the sealing ring 1-3 is arranged in the clamping claw 1-2. During the screwing process between the internal thread of the clamping nut 1-4 and the external thread 1-1-1 of the terminal body 1-1-5 of the sealing plate 1-1, the clamping claw 1-2 is pressed to force the sealing ring 1-3 to shrink and hold the cable 5 tightly, to achieve a waterproof and dustproof effect of no less than IP65.

The main plate surface of the sealing plate 1-1 is convexly arranged, at least two annular grooves 1-1-3 arranged circumferentially are provided at a junction of the edge of the sealing plate 1-1 and the main plate surface of the sealing plate 1-1, and the annular grooves 1-1-3 are each configured to install a sealing strip 3, the sealing strip 3 is connected end to end, and the edge of the sealing strip 3 is configured to fixedly connect to the electronic box body 4 by a fastener.

Specifically, the sealing strips 3 may be installed in the annular grooves 1-1-3 of the sealing plate 1-1 by pasting. The sealing strip 3 is configured to achieve the waterproof and dustproof treatment of the connection between the sealing plate 1-1 and the box body 4.

And the edge of the box body 4 is provided with a first fastening installation hole 4-1, and the sealing plate 1-1 is provided with a second fastening installation hole 1-1-4 directly opposite to the first fastening installation hole 4-1. The fasteners are arranged in the first fastening installation hole 4-1 and the second fastening installation hole 1-1-4, so that the sealing plate 1-1 is arranged on the box body 4.

Specifically, the sealing plate 1-1 is arranged on the box by the threaded fastener 2, and the threaded fastener 2 may be a screw.

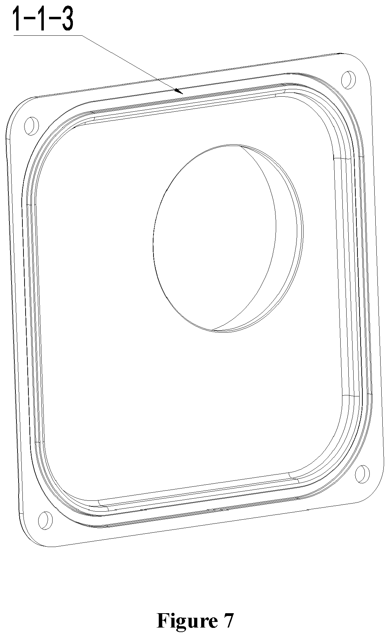

Specifically in a non-claimed embodiment, as shown in Figure 7, the number of the annular groove 1-1-3 is one.

In the claimed embodiment, the number of the annular grooves 1-1-3 is at least two, and two adjacent annular grooves 1-1-3 are arranged concentrically, and the annular grooves 1-1-3 are in one-to-one correspondence with the sealing strips 3. Preferably, two adjacent annular grooves 1-1-3 are arranged at equal intervals. Specifically, the sealing ring 1-3 and the sealing strip 3 made of rubber preferably.

In order to facilitate the assembly of the cable adapter assembly 1, preferably, the terminal body 1-1-5 is arranged to protrude from the outer surface of the sealing plate 1-1. That is, the terminal body 1-1-5 has a pipeline structure protruding from the large plate of the sealing plate 1-1, and the external thread 1-1-1 of the terminal body 1-1-5 is made by turning.

Based on the above solutions, the number of the waterproof terminal is one or at least two. When the number of the waterproof terminals is multiple, the waterproof terminals are preferably arranged at equal intervals. And in the actual installation process, the waterproof terminals may also be distributed at unequal intervals.

An electronic box according to the present application includes a box body 4 and a cable adapter assembly 1 arranged on the box body 4, where the cable adapter assembly 1 is any of the above-mentioned cable adapter assemblies 1. The foregoing describes the specific structure of the cable adapter assembly 1, and the application includes the above-mentioned cable adapter assembly 1, which also has the above technical effects.

Specifically, the sealing plate 1-1 and the box body 4 are installed by a threaded fastener, and the sealing strip 3 is compressed between the box body 4 and the sealing plate 1-1, so as to achieve waterproof and dustproof effect of no less than IP65.

Specifically, one of the cable adapter assemblies 1 or at least two of the cable adapter assemblies 1 are provided on the electronic box. When the at least two cable adapter assemblies 1 are provided, the cable adapter assemblies 1 may be arranged on the same side of the electronic box body 4 or on at least two sides. When arranged on the same side, two adjacent cable adapter assemblies 1 are arranged at equal intervals.

The above embodiments are described in a progressive manner. Each of the embodiments is mainly focused on describing its differences from other embodiments, and reference may be made among these embodiments with respect to the same or similar parts.

The above illustration of the disclosed embodiments can enable those skilled in the art to implement or use the present application.

## Claims

1. A cable adaptor assembly of an electrical box having an electrical box body (4), comprising:
a sealing plate (1-1), and
at least one waterproof terminal; the at least one waterproof terminal comprising:
a clamping claw (1-2),
a clamping nut (1-4), and
a terminal body (1-1-5);wherein an outer wall of the terminal body (1-1-5) is provided with an external thread (1-1-1) connected with the clamping nut (1-4), and the terminal body (1-1-5) and the clamping nut (1-4) are sleeved outside of the clamping claw (1-2),
the terminal body (1-1-5) and the sealing plate (1-1) have an integrated structure,
**characterized in that**, a main plate surface of the sealing plate (1-1) is convexly arranged, at least two annular grooves (1-1-3), arranged circumferentially, are provided at a junction of an edge of the sealing plate (1-1) and the main plate surface of the sealing plate, the edge is configured to fixedly connect to the electronic box body (4) by a fastener, the at least two annular grooves (1-1-3) are each configured to install a corresponding sealing strip (3), each sealing strip is connected end to end, and the at least two adjacent annular grooves are arranged concentrically.

2. The cable adaptor assembly of the electrical box according to claim 1, wherein the clamping claw (1-2) comprises an annular tube (1-2-1) and a plurality of claws (1-2-2) arranged annularly around an outer circumference of the annular tube (1-2-1), and the terminal body (1-1-5) is sleeved outside of the annular tube (1-2-1), and one end of an inner wall of the terminal body (1-1-5) away from the plurality of claws (1-2-2) is provided with a limit step (1-1-2) for abutting against an end of the annular tube (1-2-1).

3. The cable adaptor assembly of the electrical box according to claim 2, wherein the at least one waterproof terminal further comprises a sealing ring (1-3), and the clamping claw (1-2) is sleeved outside of the sealing ring (1-3), and a first end of the sealing ring (1-3) extends to an outer end surface of the claws (1-2-2).

4. The cable adaptor assembly of the electrical box according to claim 3, wherein a second end of the sealing ring (1-3) extends to an outer end surface of the annular tube (1-2-1), the outer side surface of the sealing ring (1-3) is connected with the clamping claw (1-2), and the first end and the second end are two ends of the sealing ring (1-3) arranged facing away.

5. The cable adaptor assembly of the electrical box according to claim 1, wherein the terminal body (1-1-5) is arranged to protrude from an outer surface of the sealing plate (1-1).

6. An electronic box, comprising the electrical box body (4) and a cable adapter assembly (1) arranged on the electrical box body (4), wherein the cable adapter assembly (1) is the cable adapter assembly (1) according to any one of claims 1 to 5.

7. The electronic box according to claim 6, wherein one or more cable adaptor assemblies (1) according to any one of claims 1 to 5 are provided on the electronic box.

## Patentansprüche

1. Kabeladapterbaugruppe eines Elektronikgehäuses, die einen Elektronikgehäusekörper (4) aufweist, umfassend:
eine Dichtungsplatte (1-1) und
mindestens ein wasserdichter Anschluss; wobei der mindestens eine wasserdichte Anschluss Folgendes umfasst:
mindestens eine Spannpratze (1-2),
eine Spannmutter (1-4) und
einen Anschlusskörper (1-1-5), wobei eine Außenwand des Anschlusskörpers (1-1-5) mit einem Außengewinde (1-1-1) bereitgestellt ist, das mit der Spannmutter (1-4) verbunden ist, und der Anschlusskörper (1-1-5) und die Spannmutter (1-4) außerhalb der Spannpratze (1-2) ummantelt sind,
wobei der Anschlusskörper (1-1-5) und die Dichtungsplatte (1-1) eine integrierte Struktur aufweisen,
**dadurch gekennzeichnet, dass** eine Hauptplattenfläche der Dichtungsplatte (1-1) konvex angeordnet ist, wobei mindestens zwei Ringnuten (1-1-3), die in Umfangsrichtung angeordnet sind, an einer Verbindungsstelle einer Kante der Dichtungsplatte (1-1) und der Hauptplattenfläche der Dichtungsplatte bereitgestellt sind, die Kante dazu konfiguriert ist, durch ein Befestigungsmittel fest an Elektronikgehäusekörper (4) verbunden zu sein, die mindestens zwei Ringnuten (1-1-3) jeweils dazu konfiguriert sind, einen entsprechenden Dichtungsstreifen (3) einzubauen, jeder Dichtungsstreifen von einem Ende zum anderen verbunden ist und die mindestens zwei benachbarten Ringnuten konzentrisch angeordnet sind.

2. Kabeladapterbaugruppe des Elektronikgehäuses nach Anspruch 1, wobei
die Spannpratze (1-2) einen Ringschlauch (1-2-1) und eine Vielzahl von Pratzen (1-2-2) umfasst, die ringförmig um einen Außenumfang des Ringschlauchs (1-2-1) angeordnet sind, und der Anschlusskörper (1-1-5) außerhalb des Ringschlauchs (1-2-1) ummantelt ist und ein Ende einer Innenwand des Anschlusskörpers (1-1-5) von der Vielzahl von Pratzen (1-2-2) mit einer Begrenzungsstufe (1-1-2) zum Angrenzen an einem Ende des Ringschlauchs (1-2-1) bereitgestellt ist.

3. Kabeladapterbaugruppe des Elektronikgehäuses nach Anspruch 2, wobei der mindestens eine wasserdichte Anschluss ferner einen Dichtungsring (1-3) umfasst und die Spannpratze (1-2) außerhalb des Dichtungsrings (1-3) ummantelt ist und sich ein erstes Ende des Dichtungsrings (1-3) zu einer äußeren Endfläche der Pratzen (1-2-2) erstreckt.

4. Kabeladapterbaugruppe des Elektronikgehäuses nach Anspruch 3, wobei sich ein zweites Ende des Dichtungsrings (1-3) zu einer äußeren Endfläche des Ringschlauchs (1-2-1) erstreckt, wobei die äußere Seitenfläche des Dichtungsrings (1-3) mit der Spannpratze (1-2) verbunden ist und das erste Ende und das zweite Ende zwei Enden des Dichtungsrings (1-3) sind, die abgewandt angeordnet sind.

5. Kabeladapterbaugruppe des Elektronikgehäuses nach Anspruch 1, wobei der Anschlusskörper (1-1-5) angeordnet ist, um von einer Außenfläche der Dichtungsplatte (1-1) hervorzustehen.

6. Elektronikgehäuse, umfassend den Elektronikgehäusekörper (4) und eine Kabeladapterbaugruppe (1), die an dem Elektronikgehäusekörper (4) angeordnet ist, wobei die Kabeladapterbaugruppe (1) die Kabeladapterbaugruppe (1) nach einem der Ansprüche 1 bis 5 ist.

7. Elektronikgehäuse nach Anspruch 6, wobei eine oder mehrere Kabeladapterbaugruppen (1) nach einem der Ansprüche 1 bis 5 an dem Elektronikgehäuse bereitgestellt sind.

## Revendications

1. Ensemble adaptateur de câble d'un boîtier électrique présentant un corps de boîtier électrique (4), comprenant :
une plaque d'étanchéité (1-1), et
au moins une borne étanche ; l'au moins une borne étanche comprenant :
une griffe de serrage (1-2),
un écrou de serrage (1-4), et
un corps de borne (1-1-5) ; dans lequel une paroi extérieure du corps de borne (1-1-5) est pourvue d'un filetage extérieur (1-1-1) relié à l'écrou de serrage (1-4), et le corps de borne (1-1-5) et l'écrou de serrage (1-4) sont emmanchés à l'extérieur de la griffe de serrage (1-2),
le corps de borne (1-1-5) et la plaque d'étanchéité (1-1) présentent une structure intégrée,
**caractérisé en ce qu'**une surface de plaque principale de la plaque d'étanchéité (1-1) est agencée de manière convexe, au moins deux rainures annulaires (1-1-3), agencées de manière circonférentielle, sont prévues au niveau d'une jonction d'un bord de la plaque d'étanchéité (1-1) et de la surface de plaque principale de la plaque d'étanchéité, le bord est configuré pour se relier de manière fixe au corps de boîtier électronique (4) par un élément de fixation, les au moins deux rainures annulaires (1-1-3) sont chacune configurées pour accueillir une bande d'étanchéité (3) correspondante, chaque bande d'étanchéité est reliée bout à bout, et les au moins deux rainures annulaires adjacentes sont agencées de manière concentrique.

2. Ensemble adaptateur de câble du boîtier électrique selon la revendication 1, dans lequel
la griffe de serrage (1-2) comprend un tube annulaire (1-2-1) et une pluralité de griffes (1-2-2) agencées de manière annulaire autour d'une circonférence extérieure du tube annulaire (1-2-1), et le corps de borne (1-1-5) est emmanché à l'extérieur du tube annulaire (1-2-1), et une extrémité d'une paroi intérieure du corps de borne (1-1-5) éloignée de la pluralité de griffes (1-2-2) est pourvue d'un gradin de limite (1-1-2) destiné à venir en butée contre une extrémité du tube annulaire (1-2-1).

3. Ensemble adaptateur de câble du boîtier électrique selon la revendication 2, dans lequel l'au moins une borne étanche comprend en outre une bague d'étanchéité (1-3), et la griffe de serrage (1-2) est emmanchée à l'extérieur de la bague d'étanchéité (1-3), et une première extrémité de la bague d'étanchéité (1-3) s'étend jusqu'à une surface d'extrémité extérieure des griffes (1-2-2).

4. Ensemble adaptateur de câble du boîtier électrique selon la revendication 3, dans lequel une seconde extrémité de la bague d'étanchéité (1-3) s'étend jusqu'à une surface d'extrémité extérieure du tube annulaire (1-2-1), la surface latérale extérieure de la bague d'étanchéité (1-3) est reliée à la griffe de serrage (1-2), et la première extrémité et la seconde extrémité sont deux extrémités de la bague d'étanchéité (1-3) agencées face à face.

5. Ensemble adaptateur de câble du boîtier électrique selon la revendication 1, dans lequel le corps de borne (1-1-5) est agencé pour faire saillie à partir d'une surface extérieure de la plaque d'étanchéité (1-1).

6. Boîtier électronique, comprenant le corps de boîtier électrique (4) et un ensemble adaptateur de câble (1) agencé sur le corps de boîtier électrique (4), dans lequel l'ensemble adaptateur de câble (1) est l'ensemble adaptateur de câble (1) selon l'une quelconque des revendications 1 à 5.

7. Boîtier électronique selon la revendication 6, dans lequel un ou plusieurs ensembles adaptateurs de câbles (1) selon l'une quelconque des revendications 1 à 5 sont prévus sur le boîtier électronique.
